# EUROPEAN PATENT APPLICATION

(11) **EP 0 772 036 A2**
(43) Date of publication of application: **07.05.1997**
(21) Application number: 96202926.0
(22) Date of filing: 21.10.1996
(51) Int. Cl.: G01N 3/08, G01N 3/24, G01N 19/04, H01L 21/66

(54) **Apparatus for testing bonds between an (electric) element and a support provided with conducting tracks**

(30) Priority: 31.10.1995 NL 1001532
(71) Applicant: Staudinger, Gerold, 5916 PR Venlo (NL)
(72) Inventor: Staudinger, Gerold, 5916 PR Venlo (NL)
(74) Representative: Timmermans, Anthonius C.Th., Ir.

(57) **Abstract**

A apparatus for testing the bond between an (electric) element and a support provided with conducting tracks, which apparatus includes a vertically movable arm, to which a first hook-shaped element can be attached, by means of which hook-shaped element it is possible to catch inter alia a wire which is on the one hand connected to said element and which is on the other hand connected to a conducting track on said support, and whereby a first force sensor is mounted between said hook-shaped element and said arm, whereby furthermore a second rigid element can be attached to said arm, by means of which rigid element a horizontal shearing force can be exerted on said element or on the bond between said wire and said element, whereby the apparatus furthermore includes an X-Y-table disposed under said arm, to which a support comprising one or more elements can be secured, and whereby said apparatus comprises a second horizontally disposed force sensor, by means of which the horizontal force being exerted on said element or on said bond can be measured.

## Description

A apparatus for testing bonds between an (electric) element and a support provided with conducting tracks, which apparatus includes a vertically movable arm, to which a first hook-shaped element can be attached, by means of which hook-shaped element it is possible to catch a wire which is on the one hand connected to said element and which is on the other hand connected to a conducting track on said support, and whereby a first force sensor is mounted between said hook-shaped element and said arm, whereby furthermore a second rigid element can be attached to said arm, by means of which rigid element a horizontal shearing force can be exerted on said element or on the ball bond between said wire and said element, whereby the apparatus furthermore includes an X-Y-table disposed under said arm, to which a support comprising one or more elements can be secured.

Although the apparatus according to the invention is hereinafter described by means of an application from the semiconducting track industry, it is noted that the invention can be universally applied in all cases where small mechanical connections must be tested for strength, as for example in the electronic, mechanic and medical industries.

In the semiconducting track industry a production process called bonding is used. Said bonding comprises two production stages, that is:
- die-bonding
- wire-bonding

Die-bonding normally comprises the step of attaching the element to the support by means of an adhesive film. Once the elements have been attached to the support, the unit consisting of support and elements, which forms a semifinished product, is taken to the next stage, where wire-bonding takes place.

Wire-bonding comprises the step of forming a joint between the element (chip) on the one hand and the conducting tracks on the support (printed circuit board) on the other hand. The joint is mostly formed of gold or aluminium wire having a diameter varying between 17.5 and 800 micormeters. There is a major difference between wire-bonding with gold wire and wire-bonding with aluminium wire. The gold wires are welded to the element and to the support by means of heat. The aluminium wires are attached to the element and to the support by means of an ultrasonic process.

In order to be able to test the results of the two production processes use is generally made of a so-called pull and shear test apparatus. Three tests can be carried out by means of such a testing apparatus, that is a wire pull test, a ball shear test and a die shear test.

The first test (wire pull test) comprises the testing of the strength of the wire bond as a whole (welds and connecting wire). In order to test the quality of the connecting wire and the welded connections, a pull is exerted on the wire by means of a hook, whereby a distinction may be made between a test whereby a the pull is exerted on the hook until the wire breaks or until the welded connections give way, a so-called destructive test, and a test wherein a pull being is exerted on the wire until a predetermined pull magnitude is reached, a so-called non-destructive test.

The second test (ball shear test) comprises the testing of the strength of the bond between wire and element by pushing aside the ball, the end of the connecting wire. When said bond is tested, horizontal forces are exerted on the ball by means of a rigid element, a so-called bit, which forces push the ball off the weld surface.

The third test (die shear test) comprises the testing of the strength of the bond between a element and a support, for example, by shearing off the element. This takes place in the same manner as in the preceding test, with the understanding that the rigid element, the so-called bit, exerts a horizontal force on the element until the glued joint between element and support is broken as a result of the aforesaid horizontal force.

With known apparatus for testing the bond between an electric element and a support a single sensor is used, which is mounted in the arm of the test apparatus. Either a hook-shaped element for exerting a vertical pull on the wire or a rigid element, a so-called bit, is thereby attached to said sensor for carrying out the shear test of the element from the support and/or the ball of said element.

The force sensors which are used are generally sensors built up of strain gauges or of stacked-together plates of piezo-electric material, which are connected in a Wheatstone bridge.

When testing the wire, whereby a vertical pull is exerted on the wire, no problems occur with regard to the measuring results. This kind of problems does occur, however, when the same force sensor is used for measuring the forces that are exerted when the element and/or the ball are forced aside in horizontal direction. The problem lies in the construction of the sensor, which is normally built up of several layers. It is not relevant thereby whether piezo material or strain gauges are used.

When a pull is exerted on the wire, the various layers of the force sensor are stretched, as a result of which the resistance will change. The trend of the changes in the resistance as a function of the length of the material is thereby linear. When the element or the ball is forced aside in horizontal direction, however, the various layers of the material of the force sensor are not uniformly loaded along the entire length. This will cause the Wheatstone bridge to become asymmetrical, and the trend of the changes in the resistance as a function of the length will no longer be linear. In fact the force sensor is in that case used for measuring forces in a direction for which it was not developed. This incorrect use will cause the force sensor to break down quickly and will furthermore lead to incorrect measuring results, at least when larger forces are involved.

In principle the problem of the shearing forces in fact acting on the force sensor in a wrong direction might be solved by placing the support in a vertical position and exerting a vertical shearing force on the element. If this method were used the forces exerted on the force sensor would be vertical forces again, forces in a correct direction, therefore.

When the support is placed in a vertical position, however, it is extremely difficult to assess the position of the bit by means of the usual stereo microscope, whilst furthermore a higher testing apparatus is needed for placing the support in a vertical position.

When a single value of the force at which the ball bond is broken is obtained, it is not possible to make any statements on inter alia the strength of the ball bond. Generally it is not possible to find a sound basis for a conclusion.

The object of the invention is to provide a apparatus for testing bonds between an (electric) element and a support provided with conducting tracks which does not exhibit the above drawbacks. In order to accomplish that objective the apparatus according to the invention is characterized in that said apparatus comprises a second horizontally disposed force sensor, by means of which the horizontal force being exerted on said element or on said ball bond can be measured.

With the apparatus according to the invention the force sensor which is mounted between the hook-shaped element and the arm is used for measuring the forces that occur when a vertical pull is exerted on the connecting wires between the element and the support. When the element is forced aside in horizontal direction with respect to its support, a force sensor mounted in the X-Y-table or at a location between the rigid element and the arm is used for measuring the forces that occur thereby. The rigid element, the so-called bit, is thereby mounted at a fixed location in the arm. The element is forced aside as a result of the support being moved in the horizontal Y-direction by driving and moving the X-Y-table. The sensor is thereby mounted in the apparatus in such a manner, that it can only be excited in a single direction, so that no distortion of measured value can occur. By using one sensor for measuring vertical forces, and a second sensor for measuring horizontal forces, a measuring apparatus has been obtained wherein the two sensors are only loaded in the direction for which they were designed, so that no distortion of measured values can occur. Loading a sensor in the correct direction will furthermore strongly reduce the risk of the sensor being damaged.

In another advantageous embodiment of the apparatus according to the invention the table is built up of a base part, which is guided on a further part of the X-Y-table via guide means and which supports a second part, on which the support and element can be secured, whereby the second force sensor is mounted between said second part and said base part.

In another embodiment the rigid element is coupled to the arm by means of a slide, whereby the slide includes a base part, which is secured to said arm, and a further part, to which the rigid element may be connected, whereby said second force sensor is mounted between said base part and said further part.

In another advantageous embodiment of the apparatus according to the invention at least one pair of parallel leaf springs is connected to said arm, which leaf springs are at their other side interconnected by a first plate, on which a connecting block is mounted, which connecting block supports a second plate extending parallel to said first plate, said second plate being provided with a bore, in which a first shaft is rotatably journalled, said shaft on one side of the plate being coupled to a driving motor and on the other side of said plate to an arm on which said first force sensor is mounted, whereby said force sensor comprises a second shaft whose central axis coincides with the central axis of said first shaft, and whereby said second shaft is positioned in a coaxial bore in said first plate with one end, whereby either a hook-shaped element or a rigid element, which fit in said bore with some play, or a rigid element, which is a tight fit in the bore, can be secured to said second shaft, whereby the second force sensor is furthermore mounted between a part of the arm carried by said leaf springs and a fixed part of said arm. When vertical pull forces are to be measured with said apparatus, a hook-shaped element is attached to said second shaft, for example by providing said hook-shaped element with a sleeve which fits on the end of said second shaft and which can be fixed thereto, said sleeve having an outside diameter which is smaller than the inside diameter of the bore in said first plate. The second shaft and the hook-shaped element connected thereto are rotated one turn by means of the motor and the transmission mechanism to the constructional member to which the second shaft is connected, thus enabling said hook-shaped element to catch a wire. Then the arm is moved upwards and the pull occurring in the wire that has been caught is transmitted to the force sensor via said hook-shaped element and said constructional member.

If only small shearing forces are to be measured, a rigid element is again attached to the end of said second shaft by means of a sleeve which is secured to said second shaft and which has a diameter which is smaller than the diameter of the bore. When the element to be tested is moved in horizontal direction, said element or the ball between wire and element are pressed against said rigid element, whereby horizontal shearing forces occur, which are transmitted to the force sensor via said rigid element and said constructional member. When the magnitudes of the respective shearing forces are small, said force sensor is capable of measuring said shearing forces sufficiently accurately. When the shearing forces exceed a predetermined magnitude, the measuring apparatus which is connected to the force sensor will deliver a signal to indicate to the user that larger shearing forces can no longer be handled in this manner. For forces which are larger than the shearing forces which are admissible for the first force sensor, the user will have to mount a different rigid element on the end of said second shaft, for example by means of a sleeve which fits on the shaft and which can be secured thereto, and which is a tight fit in the bore in the first plate. When shearing forces are exerted on said rigid element, said forces are directly transmitted to the first plate via said sleeve, and to the second force sensor via said first plate. Since said second force sensor is disposed horizontally between a part carried by the leaf springs and a part of the arm, the forces act on said force sensor in the right direction, so that said force sensor will measure said shearing forces very accurately.

A very robust construction has been obtained by suspending the unit from at least one pair of parallel leaf springs. The first plate is pressed against the second force sensor under the influence of the shearing forces to be measured. Said plate thereby moves a short distance, which distance corresponds with the extent to which the sensor is depressed. The leaf springs will slightly deform thereby. After the shearing forces are released, the leaf springs will return to their original position again. A next measurement can be carried out from the starting position again.

According to another embodiment the second force sensor is built up of a stack of piezo-electric plates, which stack is fixed to the base part and which butts with one rounded end against a surface of the second part, in such a manner that the second part is capable of exerting horizontal forces on the force sensor. In this manner the table is prevented from transmitting forces other than horizontal forces to the force sensor.

Another advantageous embodiment of the apparatus is characterized in that the apparatus comprises a memory for the storage of the values measured by the two force sensors, and that furthermore a display screen is present, on which the entire trend of the changes in the forces can be displayed graphically. This apparatus not only makes it possible for the user to measure the final values of the two tests, but it also enables the user to follow the changes in the forces during the tests carried out on the connecting wires as well as on the element from the moment that forces are being exerted on the element and on the wires until said forces have reached a predetermined value, or until the bond between the element and the support is broken. It may also be possible thereby to compare the changes in the forces of previous tests with the changes in the forces of an ongoing test.

The invention will be explained in more detail hereafter with reference to the drawings, in which:
Figure 1 schematically shows a apparatus for testing bonds between an (electric) element and a support;
Figures 2 and 3 are a plan view and a side view respectively of a support comprising conducting tracks and electric elements mounted thereon;
Figure 4 is a schematic view of a apparatus according to the invention, wherein a hook-shaped element is mounted in the arm;
Figure 5 shows part of the apparatus according to Figure 4, wherein a rigid element is mounted in the arm, by means of which element horizontal forces can be exerted on the element;
Figures 6 and 7 are two mutually perpendicular sectional views of an X-Y-table which can be used in the apparatus according to Figure 1;
Figure 8 is a schematic view of another embodiment of the arm; and
Figure 9 shows a further embodiment of the arm.

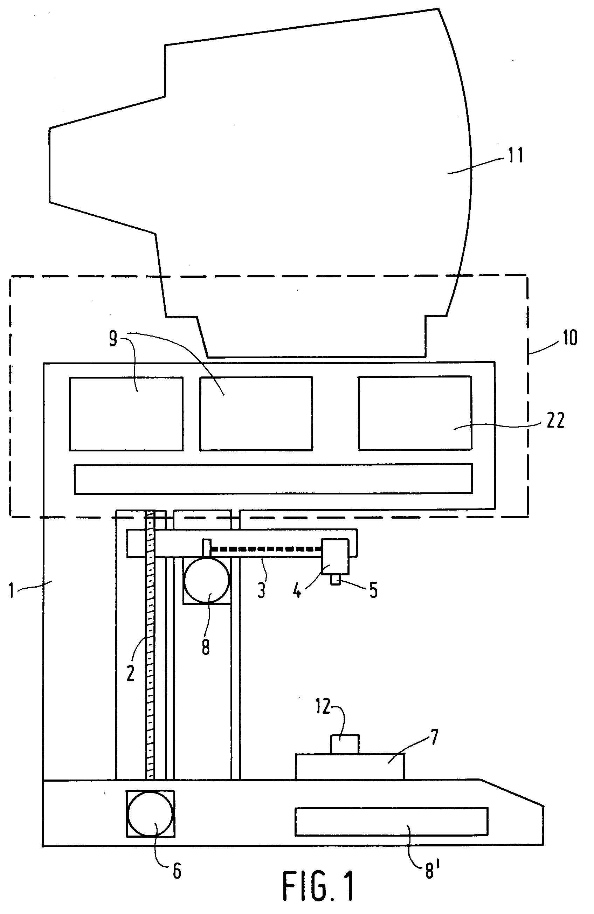

Reference numeral 1 in Figure 1 indicates a frame of a apparatus for testing bonds between an electric element and its support. Accommodated within said frame is a guide arrangement 2 for a vertically movable arm 3, in which a sensor 4 is mounted, to which either a hook-shaped element 5 or a rigid element (not shown) may be attached. The arm 3 can be moved up and down along said guide arrangement 2 by means of a motor 6. An X-Y-table, on which a element and support to be tested can be secured, is present on frame 1, under arm 3. The arm is furthermore provided with a motor 8 for rotating the head.

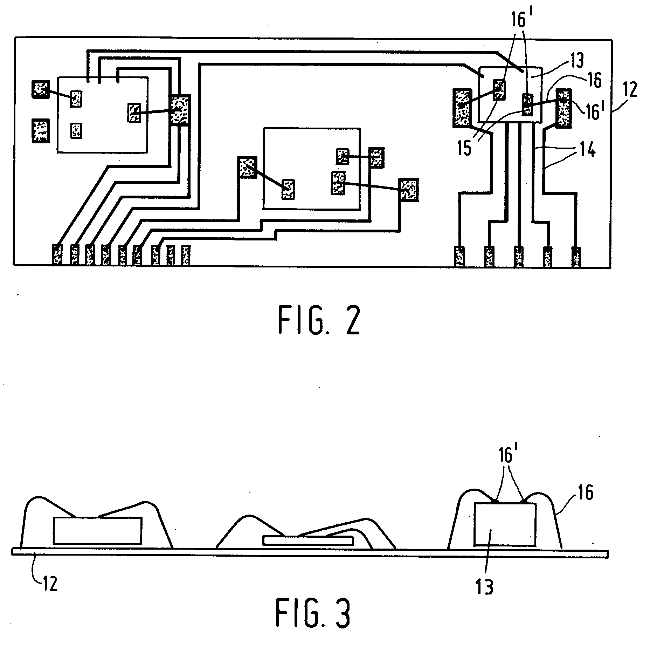

Frame 1 furthermore accommodates two motors, by means of which table 7 can be driven. Said frame furthermore accomodates force supplies 9 and a PC 10. In addition to that the apparatus comprises a monitor 11. Figures 2 and 3 schematically show, in plan view and side view respectively, a support 12 with a number of elements 13 mounted thereon. Support 12 is thereby provided with electric conducting tracks 14, and the elements are provided with contact surfaces 15. The contact surfaces 15 of the elements and the conducting tracks 14 of the support elements are connected together by connecting wires 16 (bonds), which are on the one hand attached to the conducting tracks 14 and on the other hand, by means of an adhesive film, to the contact surfaces 15. The elements 13 are thereby attached to support 12 by means of an adhesive film, for example. In order to check whether bonds between the elements 13 and the support 12 satisfy all quality standards, three tests need to be carried out.

In the first place it must be tested whether the strength of the wires 16 and their bonds 16 to the contact surfaces 15 and the conducting tracks is sufficient.

Furthermore it must be tested whether the bond between ball 16 and the contact surfaces 15 is sufficiently strong.

Finally it must be tested whether the quality of the glued joints between elements 13 and support 12 is sufficient.

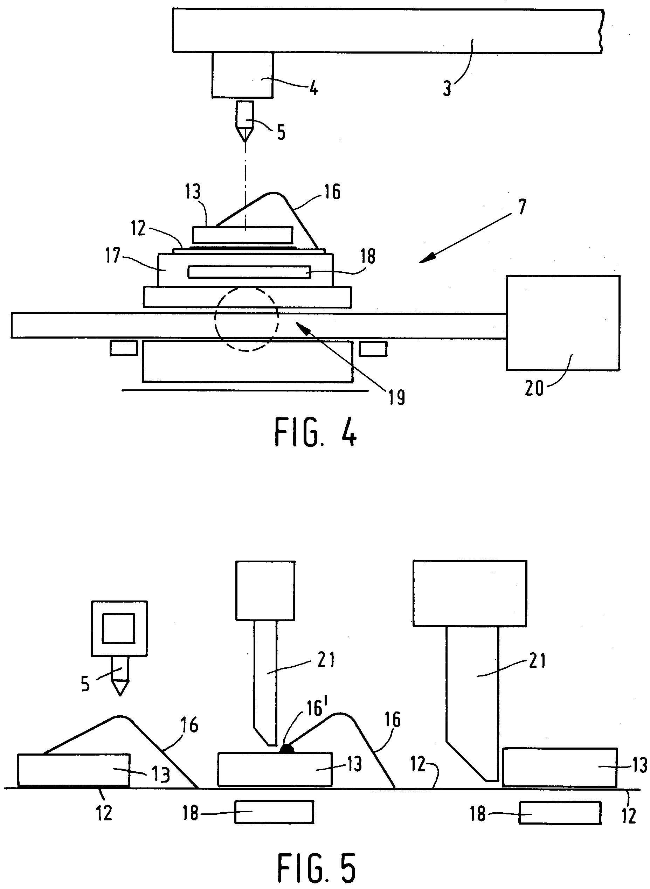

Figure 4 schematically shows a apparatus for carrying out the three above tests. Parts which correspond with parts shown in Figures 1 - 3 are indicated by the same numerals. Only those parts that are relevant for a proper understanding of the invention are shown in the apparatus according to Figure 4. The Figure shows arm 3, which is movable in vertical direction and which carries a sensor 4, to which arm a hook-shaped element 5 is attached.

Disposed under arm 3 is an X-Y-table 7, which includes a table part 17, in which a second force sensor 18 is mounted, and on which a support 12 and a element 13 attached thereto can be secured. Table part 17 is movable in horizontal direction by means of two (X-Y) driving mechanisms 19, via two motors 20.

When the strength of the wire 16 and its bonds to support 12 and element 13 is to be tested, arm 3 is in the first place moved downwards until hook 5 catches wire 16, after which arm 3 is moved upwards and the bond is subjected to a pull force. The forces that occur thereby are measured by means of sensor 4.

In order to test the bond between contact surface 15 and ball 16, said ball is loaded for shear by exerting horizontal forces thereon. This is done by connecting a rigid element 21 to sensor 4 and exerting horizontal forces on the contact surface with said rigid element. Incorrect loading of sensor 4 is prevented by the construction for securing said rigid element.

Rigid element 21 is thereby connected to arm 3 at a predetermined fixed location, whilst element 13 is moved horizontally by means of table 7, whereby a shearing force is exerted on ball 16 by rigid element 21. The shearing forces which occur in the horizontal plane thereby are measured by means of sensor 18 in table 7. Sensor 4 is thereby used for detecting the contact between rigid element 21 and support material 12 or element 13 (sensor protection).

After contact has been made arm 3 is moved slightly upwards, so that the correct contact surface between bit 21 and ball 16 is determined at all times.

In order to test the bond between element 13 and support 12 a shearing force is exerted again by means of a similar rigid element 21, in this case on element 13 itself, however. To that end arm 3 is moved downwards until it touches support 12, after which arm 3 is moved slightly upwards and is fixed in position at some distance from support 12. Then element 13 is pressed against rigid element 21 by means of table 7, so that horizontal shearing forces are exerted on element 13, which shearing forces are measured by means of sensor 18.

In this manner the vertical forces which occur during the testing of the wires 16 are measured by means of sensor 4, that is, in the direction for which said sensor has been designed, whilst the horizontal forces which occur during the other two tests are measured by means of sensor 18, whereby said forces are measured in the horizontal plane, again in the direction for which said sensor has been designed, therefore. Consequently the amount of distortion of measured values will be minimized. The measurement data thus obtained are all stored in a memory of PC 10, from which they can be retrieved and be displayed on monitor 11. A graphic illustration of the measurement data is thereby obtained, so that the user of the apparatus will get a precise picture of the changes in the forces from the beginning of the test until the end thereof. It is possible thereby to compare the changes in the forces of a test which has just been started with those of possible other tests, so that any deviations can be directly detected. This makes it possible to establish directly whether a measurement has been carried out in a correct manner or not.

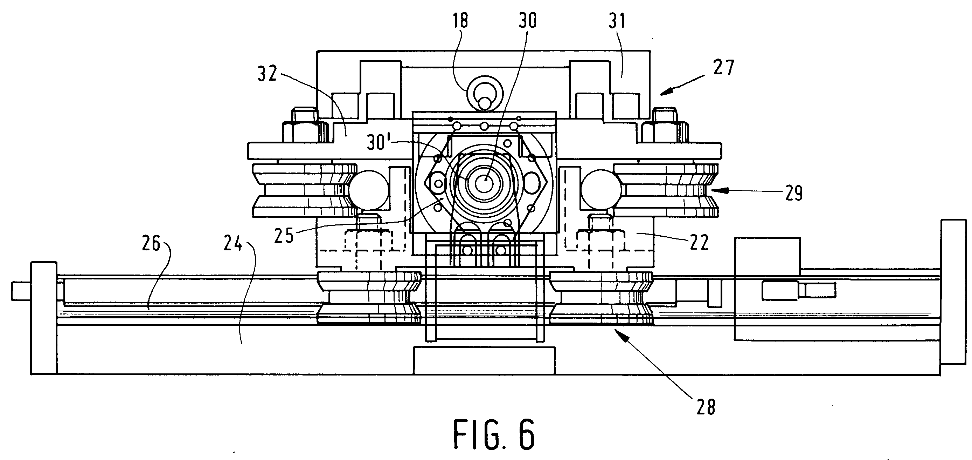

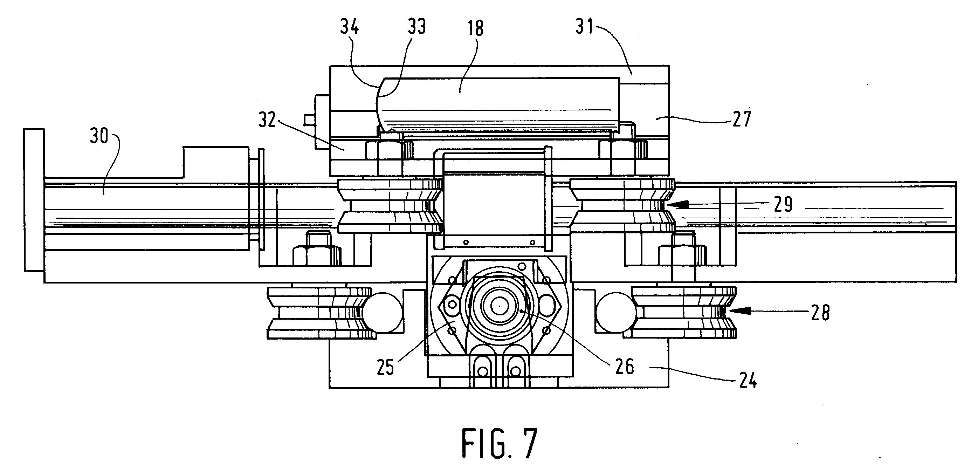

Figures 6 and 7 are two schematic, mutually perpendicular sectional views of an X-Y-table. First table part 22 is thereby guided on a base part 24 via a roller guide shoe 28. Table part 22 is provided with a guide nut construction 25, wherein a spindle 26 is capable of rotation by means of a driving mechanism (not shown). A second table part 27 is guided on said first table part 22 via a roller guide shoe 29.

Second table part 27 is also provided with a guide nut 30, in which a spindle 30 is accommodated, which can be driven via a driving mechanism (not shown). Table part 27 is thereby built up of an upper part 31 and a part 32 positioned under said upper part. A sensor 18 is mounted between table parts 31 and 32. On the one hand sensor 18 is thereby fixedly connected to the lower portion 32 of second table part 27. On the other hand sensor 18 butts with a convex surface 33 against part 34, which is fixedly connected to upper portion 33 of table part 27. A support may be secured to table part 31, and when shearing forces are exerted on a element 13 present thereon, said forces are transmitted, via table 31, to the convex end 33 of the force sensor 18, and the forces being exerted are measured by said sensor 18. The force sensor 18 is thereby built up of a number of stacked-together piezo-electric elements, and the shearing forces are thus exerted in the longitudinal direction of force sensor 18 via table 31, perpendicularly to the piezo-electric elements therefore, so that no distortion of the measured values can occur.

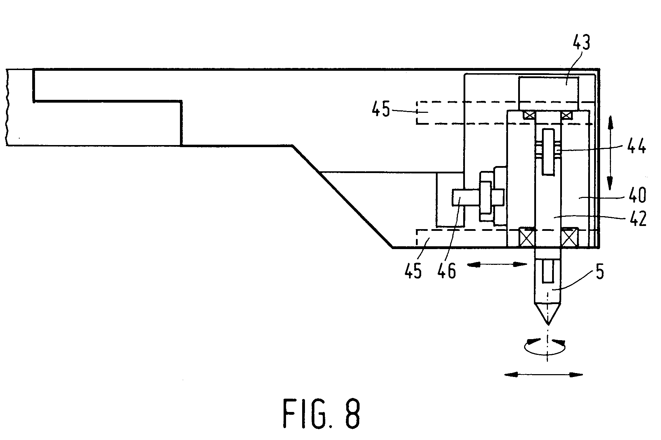

Figure 8 schematically shows another embodiment of the apparatus according to the invention. In this embodiment the second force sensor for measuring horizontal forces is not mounted in the X-Y-table disposed under the movable arm, but in arm 3 itself.

Arm 3 according to Figure 8 again includes a pick-up head 40 for picking up either a hook-shaped element 5 or a rigid element 21. A pick-up element 42 is rotatably journalled in head 40, which element is capable of picking up the hook-shaped element or the rigid element. Element 42 can be rotated by means of a motor 43, which only takes place when a wire is being caught by the hook-shaped element. A first force sensor 44 for measuring vertical forces is present in a joint between element 42 and motor 43.

In this embodiment head 40 forms a first part, which is horizontally movable, via (schematically indicated) guides 45, in a second slide portion fixedly connected to arm 3. A force sensor 46 is inserted between head 40 and said second slide portion. When a rigid bit is connected to pick-up element 42 in this embodiment, and shearing forces from a element or ball are exerted on said bit, head 40 will move slightly to the left under the influence of said forces, and exert forces on force sensor 46. Also in this embodiment it has been arranged that the vertical forces which occur when a wire is being tested are measured by a vertical force sensor, whilst the horizontal forces occurring during the shear test are measured by a horizontal force sensor.

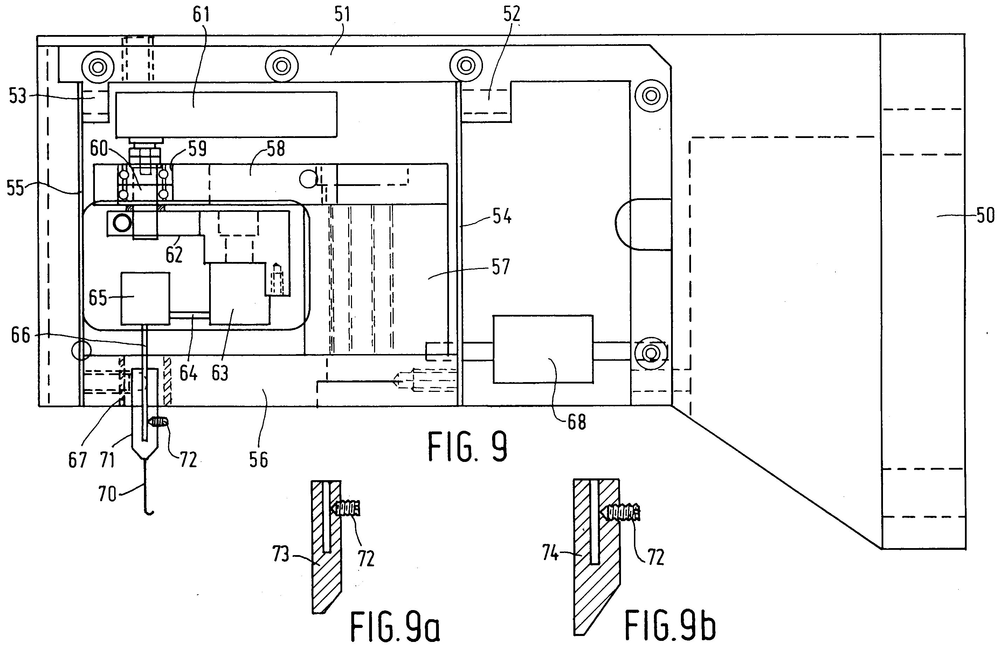

Figure 9 schematically shows another embodiment of an arm. In this Figure reference numeral 50 indicates an arm. Arm 50 is provided with a carrying portion 51, which is provided with cams 52 and 53, to which leaf springs 54 and 55 are secured. Although only two leaf springs are shown in the drawing, in reality two further leaf springs are connected to the arm, which leaf springs are staggered with respect to the illustrated leaf spring, in a direction perpendicularly to the drawing. Leaf springs 54 and 55 are connected together by a first plate 56 at their sides facing away from the extended part. Provided on said plate 56 is a block of material 57, which is provided with a second plate 58 at its upper side, which plate runs parallel with first plate 56. Second plate 58 is provided with a bore 59, in which a shaft 60 is rotatably journalled. Said shaft 60 is connected to a driving motor 61 at its upper side, and to an arm 62, which carries a first sensor 63, at its bottom side. Sensor 63 is provided with a part 64 and with a constructional part 65, which is provided with a second shaft 66, the central axis of which coincides with the central axis of first shaft 60. Shaft 66 thereby extends through a hardened sleeve 67, which is provided in a bore in first plate 56. A second force sensor 68 is provided between first plate 56 and the base part of arm 50.

The operation of this apparatus is as follows. When this apparatus is to be used to measure the pull in wires, vertical forces, therefore, a hook-shaped element 70 provided with a sleeve 71, which can be secured to shaft 66 by means of a fastening screw 72, is secured to second shaft 66. The outside diameter of sleeve 71 is thereby smaller than the inside diameter of hardened sleeve 67, so that sleeve 71 can move in sleeve 67 without friction. After arm 65 has been moved downwards, arm 62 is rotated by motor 61 via shaft 60, so that also the constructional part 65 will rotate about its own axis and the hook also makes a rotation, thereby catching a wire. When the arm 50 moves upwards, the pull occurring in the wire that has been caught will be transmitted to sensor 63 as a pull force via hook-shaped element 70, shaft 66 and constructional part, which sensor will measure said pull force and transmit it to a measuring apparatus.

When this apparatus is to be used to measure small shearing forces, a rigid element 73, also called bit, having a shape as shown in Figure 9a is mounted on second shaft 66 instead of hook-shaped element 70. At its upper end said bit 73 is sleeve-shaped, with an outside diameter which is smaller than the inside diameter of hardened sleeve 67. Moving arm 50 downwards will position the bottom end of bit 73 at the level of the part whose shearing force is to be measured, after which a force is exerted by moving the part to be tested in horizontal direction, whereby bit 73 experiences a shearing force, which it transmits to sensor 63 via shaft 66 and constructional part 65. These shearing forces can be measured up to a certain value by sensor 63 without any significant distortion. When the respective shearing forces exceed a predetermined admissible value, the measuring apparatus will deliver a signal to the user, who will then know that the sensor 63 is not able to process any forces that are greater.

When shearing forces of a value higher than the pre-adjusted admissible value are to be measured, a bit having a shape as shown in Figure 9b is mounted on shaft 66. Said bit 74 may have substantially the same shape as the bit shown in Figure 9a, but the diameter of the upper end of bit 74 substantially corresponds with the inside diameter of hardened sleeve 67, so that said bit fits therein without play. When shearing forces in horizontal direction are exerted on said bit 74, said forces will no longer be taken up by shaft 66 and be transmitted to sensor 66, but they will be directly transmitted to plate 56, which will be slightly moved in the horizontal plane in that case and transmit the forces to sensor 68, which is mounted horizontally in the apparatus. Said sensor 68 thus receives forces from plate 56 in a direction for which it has been designed, so that said sensor is capable of measuring said forces with great accuracy. By suspending plate 56 from one or more pairs of leaf springs 54, 55, a very robust construction has been obtained, which allows a slight movement of plate 56. Said leaf springs furthermore ensure that plate 56 is connected to the arm without play, so that the possibility of play, which might affect the measuring process, is ruled out when bit 74 fits tightly within hardened sleeve 67. Plate 56 is moved towards force sensor 68 under the influence of the shearing forces to be measured. Plate 56 thereby moves a small distance, which distance corresponds with the extent to which the sensor is depressed. The leaf springs allow said movement, and after the shearing forces have been released the leaf springs will return to their starting position again. Following this a next measurement may be carried out.

Although the apparatus according to the invention has hereinbefore been described by means of an application from the semiconducting track industry, it is noted that the invention can be universally applied in all cases where small mechanical connections must be tested for strength, as for example in the electronic, mechanic and medical industries.

## Claims

1. A apparatus for testing bonds between an (electric) element and a support provided with conducting tracks, which apparatus includes a vertically movable arm, to which a first hook-shaped element can be attached, by means of which hook-shaped element it is possible to catch inter alia a wire which is on the one hand connected to said element and which is on the other hand connected to a conducting track on said support, and whereby a first force sensor is mounted between said hook-shaped element and said arm, whereby furthermore a second rigid element can be attached to said arm, by means of which rigid element a horizontal shearing force can be exerted on said element or on the ball bond between said wire and said element, whereby the apparatus furthermore includes an X-Y-table disposed under said arm, to which a support comprising one or more elements can be secured, characterized in that said apparatus comprises a second horizontally disposed force sensor, by means of which the horizontal force being exerted on said element or on said ball bond can be measured.

2. A apparatus according to claim 1, characterized in that said second force sensor is mounted in said X-Y-table.

3. A apparatus according to claim 1, characterized in that said second force sensor is mounted at a location between said rigid element and said arm.

4. A apparatus according to claim 2, characterized in that said table is built up of a base part, which is guided on a further part of the X-Y-table via guide means and which supports a second part, on which the support and element can be secured, whereby said second force sensor is mounted between said second part and said base part.

5. A apparatus according to claim 3, characterized in that said rigid element is coupled to said arm by means of a slide, whereby said slide includes a base part, which is secured to said arm, and a further part, to which said rigid element may be connected, whereby said second force sensor is mounted between said base part and said further part.

6. A apparatus according to claim 3, characterized in that at least one pair of parallel leaf springs is connected to said arm, which leaf springs are at their other side interconnected by a first plate, on which a connecting block is mounted, which connecting block supports a second plate extending parallel to said first plate, said second plate being provided with a bore, in which a first shaft is rotatably journalled, said shaft on one side of the plate being coupled to a driving motor and on the other side of said plate to an arm on which said first force sensor is mounted, whereby said force sensor comprises a second shaft whose central axis coincides with the central axis of said first shaft, and whereby said second shaft is positioned in a coaxial bore in said first plate with one end, whereby either a hook-shaped element or a rigid element, which fit in said bore with some play, or a rigid element, which is a tight fit in the bore, can be secured to said second shaft, whereby said second force sensor is furthermore mounted between a part of the arm carried by said leaf springs and a fixed part of said arm.

7. A apparatus according to claim 1, 2, 3, 4 or 5, characterized in that said second force sensor is built up of a stack of piezo-electric plates, which stack is fixed to the base part and which butts with one rounded end against a surface of said second part, in such a manner that said second part is capable of exerting horizontal forces on said force sensor.

8. A apparatus according to any one of the preceding claims, characterized in that said apparatus comprises a memory for the storage of the values measured by the two force sensors, and that furthermore a display screen is present, on which said values can be displayed graphically.
